# EUROPEAN PATENT APPLICATION

(11) **EP 2 450 717 A1**
(43) Date of publication of application: **09.05.2012**
(21) Application number: 10306210.5
(22) Date of filing: 05.11.2010
(51) Int. Cl.: G01R 31/36, H02J 7/00

(54) **A system, a server, a chargeable energy storage, and a method for monitoring said chargeable energy storage**

(71) Applicant: Alcatel Lucent, 75007 Paris (FR)
(72) Inventor: Jentsch, Lothar, 15370, Fredersdorf (DE)
(74) Representative: Brose, Gerhard

(57) **Abstract**

The invention concerns a mobile chargeable energy storage (100), comprising a battery (101), a load monitoring unit (102), a position sensing unit (103) and a sender (104), wherein said load monitoring unit (102) is adapted to monitor a charging state of said battery (101), wherein said position sensing unit (103) is adapted to monitor a geographic position of said battery (101) and wherein said sender (104) is adapted to send information about said charging state and said geographic position, in particular to a server.

## Description

### Field of the invention

The invention relates to a system, a server, a chargeable energy storage as well as a method for monitoring said chargeable energy storage.

### Background

Currently a power grid network like a smart grid network is adapted to handle fixed energy destination points.

The integration of mobile chargeable energy storage inside such power grid network adds a lot of mobile energy destination points with a second important property: These mobile energy destination points, like E-Cars, E-Bikes and others, can store and provide energy by charging/discharging their batteries.

### Summary

The object of the invention is thus to provide a system, a server, a chargeable energy storage as well as a method for monitoring said chargeable energy storage.

The main idea of the invention is a chargeable energy storage, comprising a battery, a load monitoring unit, a position sensing unit and a sender, wherein said load monitoring unit is adapted to monitor a charging state of said battery, wherein said position sensing unit is adapted to monitor a geographic position of said battery and wherein said sender is adapted to send information about said charging state and said geographic position, in particular to a server. This way the geographic position and the charging state of said mobile chargeable storage are easily accessible at any given point in time.

Advantageously said mobile chargeable energy storage comprises a data storage, a unique identifier is stored in said storage and said unique identifier is sent by said sender with said information about said charging state and said geographic position. This way each chargeable mobile energy storage and hence the battery included in an individual mobile chargeable energy storage is easily identified within a system comprising multiple mobile energy storages.

Advantageously said chargeable energy storage comprises a battery management unit, and said load monitoring unit exchanges data with said battery management unit. This way the data regarding charging state is easily determined by the load monitoring unit from different battery types having individual battery management units.

Advantageously a server is adapted to receive information about said charging state and said geographic position of said battery from said sender contained in said chargeable energy storage, said server comprises a data base storing information about said battery, in particular capacity or charge current. This way additional information about said battery is available from said data base, hence reducing the amount of data sent,

Advantageously said server is adapted to receive a unique identifier with said charging state and said geographic position, wherein in said data base a unique identifier is assigned to said battery (101) and said information about said battery (101) is read from said data base upon receipt of said unique identifier. This way the additional information about said battery is easily found in said data base.

Advantageously a system comprising said mobile chargeable energy storage and said server is formed, wherein
said mobile chargeable energy storage comprising said battery, said load monitoring unit, said position sensing unit and said sender, wherein said load monitoring unit is adapted to monitor said charging state of said battery, wherein said position sensing unit is adapted to monitor said geographic position of said battery and wherein said sender is adapted to send information about said charging state and said geographic position, in particular to said server, said server is adapted to receive information about said charging state and said geographic position of said battery from said sender of said chargeable energy storage, and said server comprises said data base storing information about said battery, in particular capacity or charge current.

Advantageously in a method for monitoring said mobile chargeable energy storage comprising said battery,
said load monitoring unit monitors information about a charging state of said battery,
said position sensing unit determines a current geographic position of said battery,
said sender sends information about said charging state and said geographic position to said server,
said server receives said information about said charging state and said geographic position of said battery from said sender of said chargeable energy storage, and
said server determines information about said battery, in particular capacity or charge current from said data base.

This way information about charging state, capacity charge current or geographic position of said battery is made accessible easily via said server.

Further developments of the invention can be gathered from dependent claims and the following description.

### Brief description of the figures

In the following the invention will be explained further making reference to the attached drawings.
Fig. 1 schematically shows part of a mobile chargeable energy storage.
Fig. 2 schematically shows a flow chart, showing some typical steps in a method.

### Description of the embodiments

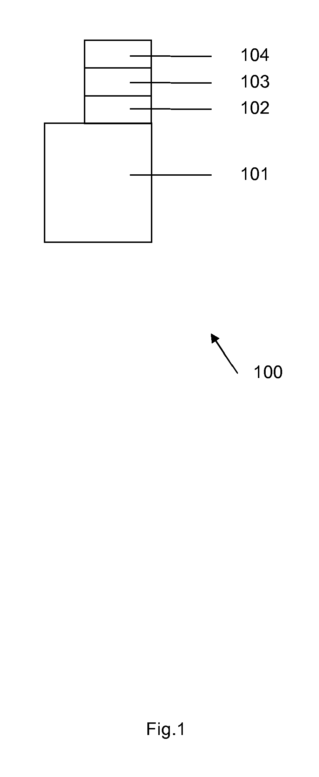

Figure 1 shows a part of a mobile chargeable energy storage 100.

Said mobile chargeable energy storage 100 comprises a battery 101, a load monitoring unit 102, a position sensing unit 103 and a sender 104.

Said load monitoring unit 102 is adapted to monitor a charging state of said battery 101. This means that said load monitoring unit determines said charging state, for example from measurements or model calculations. To this end, said load monitoring unit 102 comprises a microprocessor running an operating system and computer programs for determining charging state of batteries from measurements or model calculations. Such computer programs are known to the person skilled in the art and not explained here further.

Said position sensing unit 103 is adapted to monitor a geographic position of said battery 101. For example wireless triangulation or a global positioning system sensor is used to determine said geographic position. To this end, said position sensing unit 103 comprises a microprocessor running an operating system and computer programs for determining said geographic position using wireless triangulation or global positioning system sensors output. Such computer programs are known to the person skilled in the art and not explained here further.

Said sender 104 is adapted to send information about said charging state and said geographic position, in particular to a server. For example a wireless radio sender and the long term evolution standard, or the global system for mobile communications are used to send said information via a wireless link to a wireless access point that then connects said sender 104 to said server via a data link. Methods for sending said information are well known to the person skilled in the art and not explained here further.

Optionally said mobile chargeable energy storage 100 comprises a data storage, wherein a unique identifier is stored in said data storage. In this case said sender 104 is adapted to send said unique identifier with said information about said charging state and said geographic position.

Said server is not depicted in figure 1. However said server and said mobile chargeable energy storage 100 are adapted to form a system comprising said mobile chargeable energy storage 100 and said server. Said system may comprise of said wireless link, said data link and said wireless access point. Alternatively any other type of wired or wireless data link between said server and said mobile chargeable energy storage 100 may be used. For example a internet multimedia subsystem connection via a wireless local area network access point may be used instead.

Said server is adapted to receive information about said charging state and said geographic position of said battery 101 from said sender 104 of said chargeable energy storage 100.

Said server comprises a data base storing information about said battery 101, in particular capacity or charge current. Said capacity is for example given in watt hours. Said charge current is for example given in ampere hours.

Optionally said chargeable energy storage 100 comprises a battery management unit. In this case said battery management unit and said load monitoring unit 102 are adapted to exchange data. To this end said battery management unit is adapted to provide information about a current charging state from measurements or model calculations via a data interface. Methods for exchanging data via said data interface are known to the person skilled in the art and not explained here further.

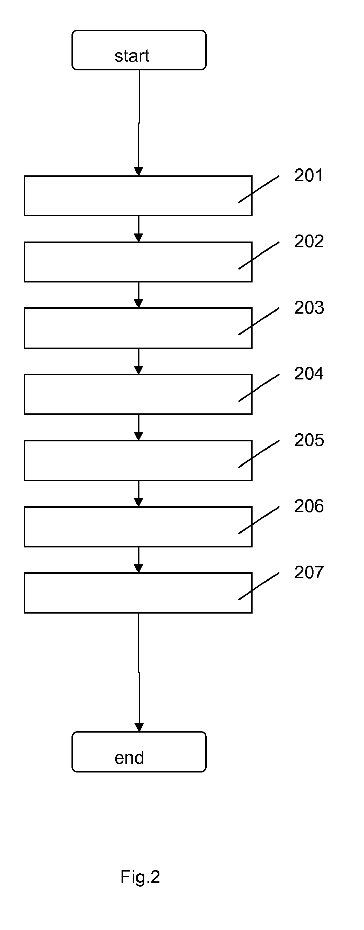

Fig. 2 schematically shows a flow chart, showing some typical steps in a method.

Said method is for example started by said operating system running on said load monitoring unit 102 of said mobile chargeable energy storage in predetermined time intervals while said mobile chargeable energy storage is used.

After the start a step 201 is executed.

In said step 201 said load monitoring unit 102 monitors information about said charging state of said battery 101.

Alternatively said information about said charging state is determined by said load monitoring unit by exchanging data with said battery management unit.

Afterwards a step 202 is executed.

In said step 202 said position sensing unit 103 determines said current geographic position of said battery 101.

Afterwards an optional step 203 is executed.

In said optional step 203 said unique identifier is read from said data storage.

Afterwards a step 204 is executed.

In said step 204 said sender 104 sends said information about said charging state, said geographic position and optionally said unique identifier to said server.

Afterwards a step 205 is executed.

In said step 205 said server receives said information about said charging state and said geographic position of said battery 101 from said sender 104 of said chargeable energy storage 100.

Afterwards a step 206 is executed.

In said step 206 said server determines information about said battery 101, in particular capacity or charge current from said data base.

Afterwards a step 207 is executed.

In said step 207 said information about said battery 101 is provided, i.e. made available. This means that for example information about said capacity, charge current, current charging state or geographic position is stored in said data base optionally associated with said unique identifier for a data base lookup request. Alternatively said information is pushed to a predetermined client or provided via a hyper text markup language interface.

Afterwards said method ends.

The steps of said method, may be performed in the order given above or in any other order.

In additional steps, time out counters may be included between the sending and receiving steps 204 and 205 in order to increase robustness. Said time out counter may trigger a restart of said method in case a predetermined time limit expired.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the figures, including any functional blocks labeled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown, in the figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams, herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

## Claims

1. A mobile chargeable energy storage (100), comprising a battery (101), a load monitoring unit (102), a position sensing unit (103) and a sender (104), **wherein** said load monitoring unit (102) is adapted to monitor a charging state of said battery (101) wherein said position sensing unit (103) is adapted to monitor a geographic position of said battery (101) and wherein said sender (104) is adapted to send information about said charging state and said geographic position, in particular to a server.

2. The mobile chargeable energy storage (100) according to claim 1, wherein said mobile chargeable energy storage (100) comprises a data storage, wherein a unique identifier is stored in said data storage and wherein said unique identifier is sent by said sender (104) with said information about said charging state and said geographic position.

3. The mobile chargeable energy storage (100) according to claim 1, wherein said chargeable energy storage (100) comprises a battery management unit, and wherein said load monitoring unit (102) exchanges data with said battery management unit.

4. A server, **adapted to** receive information about a charging state and a geographic position of a battery (101) from a sender (104) contained in a chargeable energy storage (100), wherein said server comprises a data base storing information about said battery (101), in particular capacity or charge current.

5. The server according to claim 4, adapted to receive a unique identifier with said charging state and said geographic position, wherein in said data base a unique identifier is assigned to said battery (101) and said information about said battery (101) is read from said data base upon receipt of said unique identifier.

6. A system comprising a mobile chargeable energy storage (100) and a server, wherein
said mobile chargeable energy storage (100) comprising a battery (101), a load monitoring unit (102), a position sensing unit (103) and a sender (104), wherein said load monitoring unit (102) is adapted to monitor a charging state of said battery (101), wherein said position sensing unit (103) is adapted to monitor a geographic position of said battery (101) and wherein said sender (104) is adapted to send information about said charging state and said geographic position, in particular to said server, and wherein
said server is adapted to receive information about said charging state and said geographic position of said battery (101) from said sender (104) of said chargeable energy storage (100), wherein said server comprises a data base storing information about said battery (101), in particular capacity or charge current.

7. A method for monitoring a mobile chargeable energy storage (100) comprising a battery (101), wherein
a load monitoring unit (102) monitors information about a charging state of said battery (101),
a position sensing unit (103) determines a current geographic position of said battery (101),
a sender (104) sends information about said charging state and said geographic position to a server,
said server receives said information about said charging state and said geographic position of said battery (101) from said sender (104) of said chargeable energy storage (100), and
said server determines information about said battery (101), in particular capacity or charge current from a data base.

## Amended claims

### Amended claims in accordance with Rule 137(2) EPC.

**1.** A mobile chargeable energy storage (100), comprising a battery (101), a load monitoring unit (102), a position sensing unit (103) and a sender (104), **characterized in that** said load monitoring unit (102) is adapted to monitor a charging state of said battery (101), wherein said position sensing unit (103) is adapted to monitor a geographic position of said battery (101) and wherein said sender (104) is adapted to send information about said charging state and said geographic position, in particular to a server, wherein said information is sent in predetermined time intervals.

**2.** The mobile chargeable energy storage (100) according to claim 1, wherein said mobile chargeable energy storage (100) comprises a data storage, wherein a unique identifier is stored in said data storage and wherein said unique identifier is sent by said sender (104) with said information about said charging state and said geographic position.

**3.** The mobile chargeable energy storage (100) according to claim 1, wherein said chargeable energy storage (100) comprises a battery management unit, and wherein said load monitoring unit (102) exchanges data with said battery management unit.

**4.** A server, **characterized in that** said server is adapted to receive information about a charging state and a geographic position of a battery (101) from a sender (104) contained in a chargeable energy storage (100), wherein said server comprises a data base storing information about said battery (101), in particular capacity or charge current wherein said information is sent in predetermined time intervals.

**5.** The server according to claim 4, adapted to receive a unique identifier with said charging state and said geographic position, wherein in said data base a unique identifier is assigned to said battery (101) and said information about said battery (101) is read from said data base upon receipt of said unique identifier.

**6.** A system comprising a mobile chargeable energy storage (100) and a server, **characterized in that**
said mobile chargeable energy storage (100) comprising a battery (101), a load monitoring unit (102), a position sensing unit (103) and a sender (104), wherein said load monitoring unit (102) is adapted to monitor a charging state of said battery (101), wherein said position sensing unit (103) is adapted to monitor a geographic position of said battery (101) and wherein said sender (104) is adapted to send information about said charging state and said geographic position, in particular to said server, wherein
said server is adapted to receive information about said charging state and said geographic position of said battery (101) from said sender (104) of said chargeable energy storage (100), wherein said server comprises a data base storing information about said battery (101), in particular capacity or charge current and
wherein said information is sent in predetermined time intervals.

**7.** A method for monitoring a mobile chargeable energy storage (100) comprising a battery (101), **characterized in that**
a load monitoring unit (102) monitors information about a charging state of said battery (101),
a position sensing unit (103) determines a current geographic position of said battery (101),
a sender (104) sends information about said charging state and said geographic position to a server,
said server receives said information about said charging state and said geographic position of said battery (101) from said sender (104) of said chargeable energy storage (100),
said server determines information about said battery (101), in particular capacity or charge current from a data base, and
wherein said information is sent in predetermined time intervals.
